# NEUE EUROPÄISCHE PATENTSCHRIFT

(11) **EP 1 738 382 B2**
(45) Veröffentlichungstag und Bekanntmachung des Hinweises auf die Entscheidung über den Einspruch: **09.12.2015**
(45) Hinweis auf die Patenterteilung: 28.05.2008
(21) Anmeldenummer: 05716317.2
(22) Anmeldetag: 23.03.2005
(51) Int. Cl.: H01H 47/00

(54) **SICHERHEITSSCHALTEINRICHTUNG FÜR EINE SICHERHEITSSCHALTUNG**
SAFETY SWITCH FOR A FAIL-SAFE CIRCUIT
DISPOSITIF DE COMMUTATION DE SECURITE POUR CIRCUIT DE SECURITE

(30) Priorität: 19.04.2004 DE 102004020997
(43) Veröffentlichungstag der Anmeldung: 03.01.2007
(73) Patentinhaber: Pilz GmbH & Co. KG, 73760 Ostfildern (DE)
(72) Erfinder: PULLMANN, Jürgen, 73061 Ebersbach (DE); RUPP, Roland, 73110 Hattenhofen (DE)
(74) Vertreter: Witte, Weller & Partner Patentanwälte mbB
(86) Internationale Anmeldenummer: PCT/EP2005/003079
(87) Internationale Veröffentlichungsnummer: WO 2005/101440

(56) Entgegenhaltungen:
- EP-A- 1 363 306
- EP-B1- 0 803 632
- WO-A1-01/67610
- DE-A1- 10 032 533
- DE-A1- 10 216 226
- DE-C2- 19 758 101
- US-A- 5 218 196
- US-B1- 6 417 582

## Beschreibung

Die vorliegende Erfindung betrifft eine Sicherheitsschalteinrichtung für eine Sicherheitsschaltung, mit einem Steuerteil zum Verarbeiten eines Eingangssignals und mit zumindest einem Schaltelement, das zumindest einen aktiven und einen inaktiven Schaltzustand besitzt, wobei der Steuerteil dazu ausgebildet ist, das Schaltelement anzusteuern, um ein vom Eingangssignal abhängiges Ausgangssignal an einem Ausgang zu erzeugen, ferner mit einer Diagnosefunktionalität zum Erkennen eines Funktionsfehlers, wobei der Steuerteil dazu ausgebildet ist, das Schaltelement in den inaktiven Zustand zu steuern, wenn ein Funktionsfehler erkannt ist.

Die Erfindung betrifft ferner eine Sicherheitsschaltung zum fehlersicheren Abschalten einer gefahrbringenden Anlage, mit einer Vielzahl von derartigen Sicherheitsschalteinrichtungen und mit einer übergeordneten Sicherheitssteuerung, die dazu ausgebildet ist, einen Stromversorgungspfad zu der Anlage zu unterbrechen.

Eine solche Sicherheitsschalteinrichtung und eine entsprechende Sicherheitsschaltung sind aus EP 1 363 306 A2 bekannt.

EP 1 363 306 A2 beschreibt eine Sicherheitsschalteinrichtung, die zur Stellungsüberwachung von Schutzgittern, Schutztüren, Maschinenverkleidungsteilen oder anderen Schutzeinrichtungen zum Absichern von rotierenden Maschinenteilen oder anderen Gefahrstellen vorgesehen ist. Eine solche Sicherheitsschalteinrichtung wird häufig auch als Sicherheitsschalter oder als Meldegerät für eine Sicherheitsschaltung bezeichnet. Der Sicherheitsschalter (oder etwas allgemeiner das Meldegerät) dient dazu, ein sicherheitsrelevantes Eingangssignal zu erzeugen, das einer übergeordneten Sicherheitssteuerung zugeführt ist. Die Sicherheitssteuerung ist dazu ausgebildet, die Eingangssignale mehrerer Meldegeräte auszuwerten und in Abhängigkeit davon eine gefahrbringende Anlage in einen sicheren Zustand zu bringen, beispielsweise also bewegte Antriebe zu schalten. Dabei ist die Sicherheitssteuerung in aller Regel getrennt von der Betriebssteuerung der Anlage realisiert, da die Sicherheitssteuerung erheblich höhere Anforderungen an ihre Eigenfehlersicherheit erfüllen muss als eine "einfache" Betriebssteuerung.

Sicherheitsschalteinrichtungen im Sinne der vorliegenden Erfindung sind jedoch nicht nur Meldegeräte, sondern auch sog. Sicherheitsschaltgeräte und sogar Sicherheitssteuerungen, d.h. auch solche Geräte, die Eingangssignale von Meldegeräten auswerten. Gleichwohl liegt der bevorzugte Anwendungsbereich der vorliegenden Erfindung bei Meldegeräten für sicherheitstechnische Anwendungen. Zum Teil werden solche Meldegeräte auch als Sensoren bezeichnet.

Meldegeräte/Sensoren für sicherheitstechnische Anwendungen müssen ebenso wie die Sicherheitssteuerungen/Sicherheitsschaltgeräte fehlersicher aufgebaut sein, um zu gewährleisten, dass die vorgesehene Sicherheitsfunktion jederzeit erfüllt ist. Intelligente Sensoren, beispielsweise Lichtschranken oder Lichtgitter, sind daher üblicherweise eigenfehlersicher aufgebaut, so dass sie die Kategorien 3 oder sogar 4 der europäischen Norm EN 954-1 oder vergleichbare Sicherheitsanforderungen erfüllen. Einfache Meldegeräte, wie etwa Not-Aus-Taster, Schutztürschalter, Zwei-Hand-Schalter u.ä. sind zwar in aller Regel auch redundant, sie besitzen in der Praxis jedoch keine oder nur eine begrenzte Intelligenz. Eine Fehlerüberwachung wird dann in aller Regel mit Hilfe der übergeordneten Sicherheitssteuerung oder dem übergeordneten Sicherheitsschaltgerät realisiert.

Die eingangs genannte EP 1 363 306 A2 offenbart einen Sicherheitsschalter, der eine eigene Diagnosefunktionalität aufweist. Insbesondere ist der beschriebene Sicherheitsschalter in der Lage, durch Rücklesen seiner Ausgangssignale die Funktion der verwendeten Schaltelemente zu überwachen.

Die Druckschrift beschreibt ferner eine Sicherheitsschaltung, in der mehrere solche Sicherheitsschalter in Reihe zueinander an eine übergeordnete Sicherheitssteuerung angeschlossen sind. Dabei wird ein Freigabesignal durch die Schaltelemente der einzelnen Sicherheitsschalter bis zu der übergeordneten Sicherheitssteuerung durchgeschleift. Sobald einer der Sicherheitsschalter das Freigabesignal mit Hilfe seiner Schaltelemente unterdrückt, fehlt das Freigabesignal an der Sicherheitssteuerung, die daraufhin die überwachte Anlage in eine sichere Ruheposition bringt.

Bei der beschriebenen Sicherheitsschaltung ist es allerdings nicht möglich, dass die einzelnen Sicherheitsschalter (Meldegeräte) die Ergebnisse ihrer Diagnose der Sicherheitssteuerung mitteilen. Somit ist zwar ein schnelles Abschalten der überwachten Anlage gewährleistet, ein Rückschluss auf die Ursache für das Abschalten ist jedoch nicht möglich.

Bei intelligenteren Sensoren, wie etwa Lichtschranken oder Lichtgittern, ist es bekannt, Diagnoseinformationen an eine übergeordnete Sicherheitssteuerung zu melden, wobei für diesen Zweck eigene Diagnoseleitungen oder ein Feldbusanschluss genutzt wird. Dies wäre für "kleine" Meldegeräte, insbesondere mechanisch betätigte Meldegeräte, zu aufwändig und zu teuer.

Vor diesem Hintergrund ist es eine Aufgabe der vorliegenden Erfindung, eine Sicherheitsschalteinrichtung der eingangs genannten Art anzugeben, die den kostengünstigen Aufbau einer Sicherheitsschaltung mit umfassenden Diagnosemöglichkeiten erlaubt.

Diese Aufgabe wird durch eine nach Anspruch 1 Sicherheitsschalteinrichtung gelöst.

Eine entsprechende Sicherheitsschaltung beinhaltet dementsprechend eine Sicherheitssteuerung, die dazu ausgebildet ist, die Datentelegramme der Sicherheitsschalteinrichtungen aufzunehmen und zu verarbeiten.

Die vorliegende Erfindung beruht damit auf der Idee, die Diagnoseinformationen einer Sicherheitsschalteinrichtung auf den vorhandenen Sicherheitsleitungen zu übertragen, mit denen die Sicherheitsschalteinrichtung einen Abschaltbefehl an die übergeordnete Steuerung überträgt. Ein Feldbusanschluss oder zusätzliche Diagnoseleitungen können damit eingespart werden. Dies ist abweichend von allen bisherigen Ansätzen ohne weiteres möglich, da die vorhandenen Sicherheitsleitungen (die Sicherheitsausgänge) nach dem Abschalten einer überwachten Anlage bis zum erneuten Inbetriebnehmen der Anlage funktionslos sind. In dieser Phase können also Diagnosedaten an die übergeordnete Sicherheitssteuerung übertragen werden.

Die erfindungsgemäße Anordnung spart Anschlüsse an den einzel nen Geräten und sie ermöglicht den Aufbau einer Sicherheitsschaltung mit einer umfassenden Diagnosefunktionalität, jedoch mit geringem Verdrahtungsaufwand. Bevorzugt sind Meldegeräte oder andere Sicherheitsschalteinrichtungen in Reihe zueinander an die übergeordnete Sicherheitssteuerung angeschlossen, um den Verdrahtungsaufwand weiter zu reduzieren.

Die neue Sicherheitsschalteinrichtung ermöglicht damit einen kostengünstigen und flexiblen Aufbau einer Sicherheitsschaltung mit umfassender Diagnosefunktionalität, jedoch ohne den Aufwand und die Kosten zusätzlicher Kommunikationsleitungen. Die genannte Aufgabe ist daher vollständig gelöst.

In einer bevorzugten Ausgestaltung der Erfindung ist der Steuerteil dazu ausgebildet, das Datentelegramm mit Hilfe des zumindest einen Schaltelements zu erzeugen.

Alternativ hierzu könnte der Steuerteil zu Erzeugen des Datentelegramms auch ein zusätzliches Schaltelement ansteuern, das an die Ausgangsleitung angeschlossen ist. Die Verwendung des vorhanden Schaltelements spart jedoch weitere Kosten und verringert den erforderlichen Bauraum.

In einer weiteren Ausgestaltung besitzt die neue Sicherheitsschalteinrichtung zumindest zwei zueinander redundante Schaltelemente, die von dem Steuerteil redundant ansteuerbar sind.

Die Verwendung redundanter Schaltelemente ist im Bereich der Sicherheitstechnik für sich genommen hinreichend bekannt. Im Rahmen der vorliegenden Erfindung erhöht die Verwendung redundanter Schaltelemente jedoch nicht nur die Funktionssicherheit, sondern auch die Verfügbarkeit. Selbst wenn also eines der Schaltelemente auf Grund eines Funktionsfehlers (Durchlegieren bei Halbleiterschaltelementen, Kontaktverschweißen bei Relais etc.) nicht mehr in der Lage ist, Schaltfunktionen auszuführen, kann die neue Sicherheitsschalteinrichtung gleichwohl sämtliche Diagnoseinformationen über den redundanten Kanal absetzen. Zwar würde das Fehlen jeglicher Diagnosedaten auf das Versagen der ausgangsseitigen Schaltelemente hindeuten, die vorliegende Ausgestaltung ermöglicht jedoch eine noch umfangreichere Diagnose, ohne den Verdrahtungs- und Kostenaufwand nennenswert zu vergrößern.

In einer weiteren Ausgestaltung ist der Steuerteil dazu ausgebildet, das Schaltelement pulsweise anzusteuern, um ein pulsförmiges Datentelegramm zu erzeugen.

Die Verwendung pulsförmiger Datentelegramme lässt sich technisch sehr einfach realisieren. Sie bietet andererseits die Möglichkeit, auch große Datenmengen mit seriellen Protokollen über wenige Leitungen zu übertragen. Damit ist die Verwendung pulsförmiger Datentelegramme eine besonders kostengünstige Möglichkeit, um einen hohen Diagnosegrad mit geringem Verdrahtungsaufwand zu erreichen.

In einer weiteren Ausgestaltung ist der Steuerteil dazu ausgebildet, eine Adresse in das Datentelegramm einzubinden.

Damit ist es möglich, dass jedes Meldegerät, allgemeiner jede Sicherheitsschalteinrichtung, ihre Identität der übergeordneten Steuerung mitteilt. Eine detaillierte Diagnose der gesamten Sicherheitsschaltung ist damit noch einfacher und gezielter möglich.

In einer weiteren Ausgestaltung besitzt die neue Sicherheitsschalteinrichtung zumindest einen Eingang für ein externes Freigabesignal, welches das Eingangssignal bildet.

Diese Ausgestaltung ist besonders vorteilhaft, um die Diagnosedaten seriell von einer Sicherheitsschalteinrichtung zur nächsten zu übertragen. Eine stromabwärts liegende Sicherheitsschalteinrichtung kann die Diagnosedaten einer stromaufwärts liegenden Sicherheitsschalteinrichtung über den genannten Eingang empfangen und ausgangsseitig nachbilden. Darüber hinaus hat die stromabwärts liegende Sicherheitsschalteinrichtung in dieser Ausgestaltung die Möglichkeit, die empfangenen Diagnosedaten zu ergänzen und/oder zu verändern, wenn dies gewünscht ist. Die Diagnosemöglichkeiten sind damit noch flexibler.

In einer weiteren Ausgestaltung besitzt die neue Sicherheitsschalteinrichtung einen Initialisierungsmodus, in dem der Steuerteil mit Hilfe des zumindest einen Schaltelements eine Pulsfolge erzeugt, die mehr Pulse beinhaltet, als ein an dem Eingang zugeführtes Freigabesignal.

Diese Ausgestaltung ermöglicht auf sehr einfache und kostengünstige Weise eine automatische Adresszuweisung an mehrere, in Reihe zueinander angeordnete Sicherheitsschalteinrichtungen. Wie an Hand eines bevorzugten Ausführungsbeispiels weiter unten beschrieben ist, wird durch das Hinzufügen von Impulsen eine Adressvergabe nach Art eines "Durchzählens" realisiert. Die damit verbundene Automatik passt sich an Änderungen der Sicherheitsschaltung (Hinzufügen oder Wegnehmen einer Sicherheitsschalteinrichtung) an und vermeidet daher Fehler. Darüber hinaus ist diese Art der Adressvergabe ohne zusätzlichen Hardwareaufwand möglich und daher kostengünstig.

In einer weiteren Ausgestaltung besitzt die neue Sicherheitsschalteinrichtung zumindest einen Eingangsteil für einen Betätiger, der zwischen einem ersten und zumindest einem zweiten Zustand wechselbar ist, wobei der Eingangsteil das Eingangssignal erzeugt.

Diese Ausgestaltung präzisiert die neue Sicherheitsschalteinrichtung als Meldegerät. Da in einer komplexen Sicherheitsschaltung häufig eine Vielzahl von Meldegeräten mit einer oder wenigen Sicherheitssteuerungen verbunden werden müssen, wirken sich die Vorteile der Erfindung in dieser Ausgestaltung besonders deutlich aus. Besonders vorteilhaft ist die vorliegende Erfindung bei mechanisch betätigten Meldegeräten, insbesondere also Schutztürschaltern, Not-Aus-Tastern, Zwei-Hand-Schaltern, Start- oder Befehlstastern sowie Positionsschaltern. Diese "einfachen" Meldegeräte sind nämlich bislang nur mit geringen Diagnosefunktionalitäten ausgerüstet, wenn überhaupt. Darüber hinaus handelt es sich um vergleichsweise kostengünstige Komponenten, beispielsweise im Vergleich zu einer intelligenten Lichtschranke, weshalb sich ein hoher Aufwand für die Implementierung von Diagnosefunktionalitäten bislang nicht lohnte. Mit der vorliegenden Erfindung können jedoch gerade diese einfachen Meldegeräte mit einer hohen Diagnosefunktionalität, aber geringem Verdrahtungsaufwand an eine übergeordnete Sicherheitssteuerung angeschlossen werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer Anlage, bei der ein Meldegerät gemäß der vorliegenden Erfindung zur Absicherung eingesetzt wird,
- Fig. 2: eine schematische Darstellung eines Ausführungsbeispiels des neuen Meldegerätes,
- Fig. 3: eine Sicherheitsschaltung mit zwei Meldegeräten der in Fig. 2 gezeigten Art in einer Reihenanordnung, und
- Fig. 4: eine Zeitdiagramm mit Signalverläufen beim Initialisieren einer Sicherheitsschaltung gemäß Fig. 3.

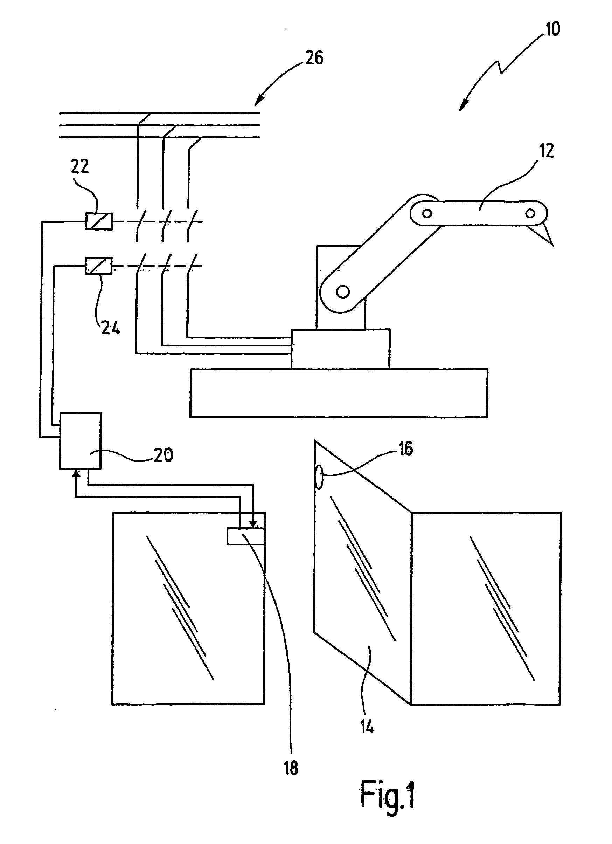

In Fig. 1 ist eine Anlage, die mit Hilfe der Erfindung abgesichert wird, in ihrer Gesamtheit mit der Bezugsziffer 10 bezeichnet.

Die Anlage 10 beinhaltet hier einen Roboter 12, dessen automatisierte Bewegungen für eine Person (hier nicht dargestellt), die sich im Bewegungsbereich des Roboters 12 aufhalten würde, gefährlich wären. Daher ist der Bewegungsbereich des Roboters 12, wie an sich bekannt, mit einer Schutztür 14 und Schutzzäunen abgesichert. An der Schutztür 14 ist ein Betätiger 16 befestigt. An einem feststehenden Rahmen, an dem die Schutztür 14 in geschlossenem Zustand anliegt, befindet sich ein Sicherheitsschalter 18, allgemeiner also ein Meldegerät gemäß der vorliegenden Erfindung. Der Sicherheitsschalter 18 ist über mehrere Leitungen mit einer Sicherheitssteuerung 20 verbunden. Die Sicherheitssteuerung 20 steuert ausgangsseitig zwei Schütze 22, 24, deren Kontakte die Stromversorgung 26 zum Roboter 12 unterbrechen können.

Die Anlage 10 ist hier vereinfacht dargestellt. Wie den einschlägigen Fachleuten bekannt ist, wird die Schutztür 14 in der Praxis üblicherweise mit zumindest zwei Sicherheitsschaltern 18 und entsprechenden Betätigern 16 ausgerüstet, wobei einer der Sicherheitsschalter häufig verdeckt angeordnet wird, um Manipulationen zu erschweren. Darüber hinaus enthält eine solche Anlage häufig weitere Meldegeräte, wie beispielsweise Not-Aus-Taster oder weitere Schutztürschalter (hier nicht gezeigt). Außerdem ist hier die erforderliche Betriebssteuerung für den Roboter 12 der Einfachheit halber nicht dargestellt.

Die Sicherheitssteuerung 20 kann in einem einfachen Szenario ein Sicherheitsschaltgerät sein, wie es von der Anmelderin unter der Bezeichnung PNOZ^{®} angeboten wird. Wenn zahlreiche sicherheitstechnische Meldegeräte zur Absicherung der Anlage 10 benötigt werden, ist es jedoch vorteilhaft, eine komplexere Sicherheitssteuerung einzusetzen, wie etwa die unter der Bezeichnung PSS^{®} von der Anmelderin vertriebenen Sicherheitssteuerungen. Zumindest im letztgenannten Fall besitzt die Sicherheitssteuerung 20 üblicherweise einen Feldbusanschluss und weitere Schnittstellen zur Kommunikation mit der hier nicht gezeigten Betriebssteuerung und/oder zur Kommunikation mit einem übergeordneten Leitrechner.

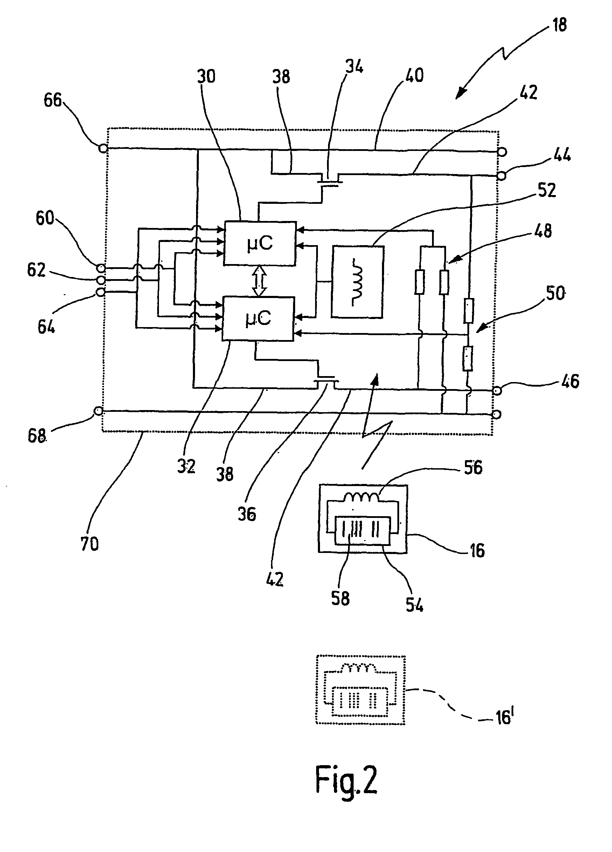

In dem bevorzugten Ausführungsbeispiel gemäß Fig. 2 ist der Sicherheitsschalter 18 zweikanalig-redundant aufgebaut. Dementsprechend besitzt der Sicherheitsschalter 18 hier zwei redundante Mikrocontroller 30, 32, die sich gegenseitig überwachen, was durch einen Doppelpfeil zwischen den Mikrocontrollern dargestellt ist. In bevorzugten Ausführungsbeispielen sind die Mikrocontroller unterschiedlich, d.h. der Sicherheitsschalter 18 ist diversitär aufgebaut.

Mit den Bezugsziffern 34, 36 sind zwei elektronische Schaltelemente bezeichnet, die hier als Feldeffekttransistoren dargestellt sind. Alternativ können jedoch auch bipolare Transistoren oder andere, vorzugsweise elektronische Schaltelemente eingesetzt werden.

Der Steueranschluss (Gate) des Schaltelements 34 ist mit dem Mikrocontroller 30 verbunden. Der Eingang 38 (Source) ist mit einer Leitung 40 verbunden, an der im Betrieb des Sicherheitsschalters 18 eine Betriebsspannung U_{B} anliegt. Der Ausgang 42 (Drain) ist mit einem Anschluss 44 verbunden, an dem der Sicherheitsschalter 18 extern verdrahtet werden kann. Damit bildet der Ausgang 42 des Schaltelements 34 ein Ausgangssignal des Sicherheitsschalters 18.

Das zweite Schaltelement 36 ist an seinem Steueranschluss (Gate) mit dem Mikrocontroller 32 verbunden. Sein Eingang 38 liegt ebenfalls über die Leitung 40 an Betriebsspannung U_{B}.

Sein Ausgang 42 ist einem zweiten Ausgangsanschluss 46 des Sicherheitsschalters 18 zugeführt.

Die Signale an den Ausgängen 42 der Schaltelemente 34, 36 sind über zwei Spannungsteiler 48, 50 auf die Mikrocontroller 30, 32 zurückgekoppelt. Damit ist es den Mikrocontrollern 30, 32 möglich, den jeweiligen Schaltzustand der Schaltelemente 34, 36 zu überwachen.

Mit der Bezugsziffer 52 ist ein Eingangsteil bezeichnet, mit dessen Hilfe die Mikrocontroller 30, 32 den aktuellen Zustand des Betätigers 16 bestimmen. In dem hier gezeigten, bevorzugten Ausführungsbeispiel ist der Betätiger 16 ein Transponder mit einem Signalerzeugungsschaltkreis 54 und einer Sende- und Empfangsspule 56. In dem Signalerzeugungsschaltkreis 54 ist eine individuelle Codierung 58 abgespeichert. Der Eingangsteil 52 besitzt ebenfalls eine Sende- und Empfangsspule (hier nur symbolisch dargestellt), über die er ein Abfragesignal aussendet. Sobald sich der Transponder 16 im Nahbereich des Eingangsteils 52 befindet (Schutztür geschlossen), wird der Signalerzeugungsschaltkreis 54 im Betätiger 16 aktiviert. Der Betätiger 16 sendet dann die abgespeicherte Codierung 58 an den Eingangsteil 52 zurück. Dort wird die Codierung 58 aus dem empfangenen Signal demoduliert und den Mikrocontrollern 30, 32 zur Verfügung gestellt.

Ist die Schutztür 14 hingegen geöffnet, befindet sich der Betätiger 16 außerhalb der Sende- und Empfangsreichweite des Eingangsteils 52, was in Fig. 2 bei der Position 16' dargestellt ist. In diesem Fall findet zwischen Betätiger 16 und Eingangsteil 52 keine Kommunikation statt. Die Mikrocontroller 30, 32 erhalten folglich keine Codierung, was als geöffnete Schutztür 14 interpretiert wird. Ist ein zweiter Schütztürschalter oder zumindest ein zweiter Betätiger (nicht dargestellt) vorhanden, kann auch ein Defekt des Betätigers 16 oder des Eingangsteils 52 erkannt werden. Die Verwendung von Transpondern zum Überwachen von Schutztüren ist für sich genommen im Bereich der Sicherheitstechnik bekannt, beispielsweise aus EP 0 968 567 B1.

In anderen Ausführungsbeispielen kann der Eingangsteil 52 für andere Arten von Betätigern ausgebildet sein. Dabei kann der Betätiger auch im Sicherheitsschalter 18 integriert sein. Beispielsweise könnte der Sicherheitsschalter 18 ein Not-Aus-Taster sein und der Betätiger ist in diesem Fall der Stößel des Tasters. In weiteren Ausführungsbeispielen beinhaltet der Eingangsteil 52 induktive, kapazitive, optische oder anderweitige Sensoren zum Bestimmen einer aktuellen Position eines mechanisch beweglichen Betätigers. Darüber hinaus kann die Erfindung grundsätzlich auch bei Lichtschranken und anderen Meldegeräten angewendet werden, die zwischen zumindest zwei Zuständen unterscheiden.

Eingangsseitig besitzt der Sicherheitsschalter 18 hier drei Anschlüsse 60, 62, 64, die jeweils als Sicherheitseingänge ausgebildet sind und redundant mit den beiden Mikrocontrollern 30, 32 verbunden sind. Über die Anschlüsse 60 bis 64 können den Mikrocontrollern 30, 32 externe Freigabesignale redundant zugeführt werden. Außerdem ist in an sich bekannter Weise ein Anschluss 66 zum Zuführen einer Betriebsspannung U_{B} und ein Masseanschluss 68 vorhanden. Es versteht sich, dass die genannten Anschlüsse jeweils an der Außenseite eines Gehäuses 70 des Sicherheitsschalters 18 zugänglich sind.

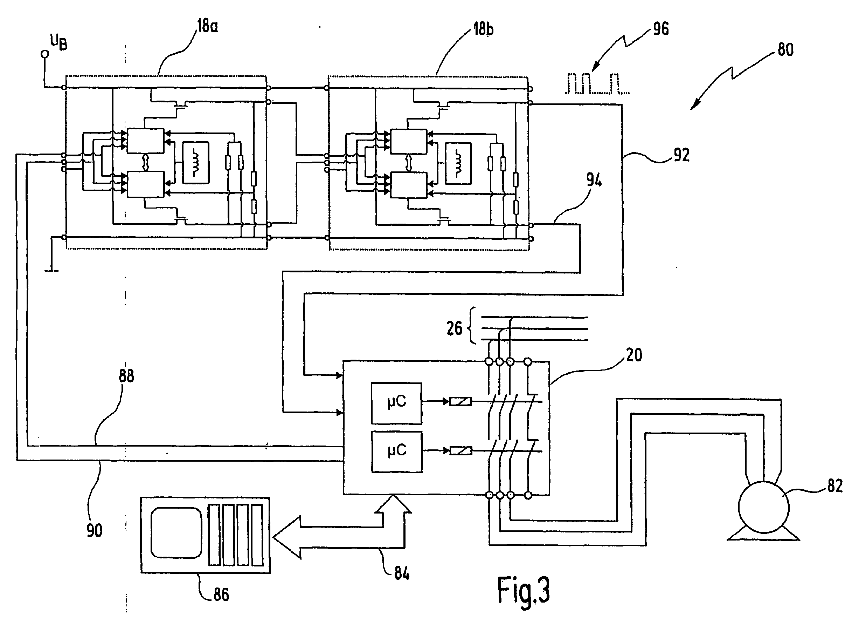

In Fig. 3 ist eine Sicherheitsschaltung mit zwei der beschriebenen Sicherheitsschalter 18 in ihrer Gesamtheit mit der Bezugsziffer 80 bezeichnet. Im übrigen bezeichnen gleiche Bezugszeichen dieselben Elemente wie zuvor. Die beiden Sicherheitsschalter sind zur gegenseitigen Unterscheidung mit 18a und 18b bezeichnet.

Der Sicherheitsschalter 18a ist an seinen Anschlüssen 60, 62 mit Ausgängen der Sicherheitssteuerung 20 verbunden. Bevorzugt handelt es sich hierbei um sogenannte Taktausgänge der Sicherheitssteuerung 20, an denen zwei Taktsignale unterschiedlicher Frequenz anliegen, so dass eine Querschlusserkennung sowohl im Sicherheitsschalter 18a als auch (durch Rücklesen, hier nicht gezeigt) in der Sicherheitssteuerung 20 möglich ist. Außerdem ist der Sicherheitsschalter 18a an den Anschlüssen 66, 68 mit Betriebsspannung U_{B} bzw. Masse verbunden. Ausgangsseitig sind die Anschlüsse 44, 46 des Sicherheitsschalters 18a auf die Anschlüsse 60, 62 des nachfolgenden Sicherheitsschalters 18b geführt. Die beiden Sicherheitsschalter 18a, 18b sind also in Reihe zueinander angeordnet. Betriebsspannung erhält der Sicherheitsschalter 18b in der gezeigten Anordnung ebenfalls vom Sicherheitsschalter 18a. Alternativ hierzu könnte der Sicherheitsschalter 18b jedoch auch mit einer anderen Quelle für die Betriebsspannung U_{B} verbunden sein.

Die beiden Ausgangssignale des Sicherheitsschalters 18b, d.h. die an dessen Anschlüssen 44, 46 anliegenden Signale, sind Sicherheitseingängen der Sicherheitssteuerung 20 zugeführt.

Ausgangsseitig ist die Sicherheitssteuerung 20 zwischen die Stromversorgung 26 und einen abzuschaltenden Antrieb 82, beispielsweise einen Stellantrieb des Roboters 12, geschaltet. Außerdem ist hier schematisch dargestellt, dass die Sicherheitssteuerung 20 über einen Feldbus 84 mit einer Betriebssteuerung 86 für den Roboter 12 und/oder einem übergeordneten Leitrechner verbunden ist. Die zu den Sicherheitsschaltern 18a, 18b gehörenden Betätiger sind aus Gründen der Übersichtlichkeit in Fig. 3 nicht gezeigt.

Die Funktionsweise der Sicherheitsschaltung 80 ist wie folgt:

Nach der Inbetriebnahme erzeugt die Sicherheitssteuerung 20 an ihren Ausgängen zwei Taktsignale 88, 90, die dem Sicherheitsschalter 18a als Freigabesignale zugeführt sind. Die Mikrocontroller 30, 32 des Sicherheitsschalters 18a überwachen mit Hilfe des Eingangsteils 52 den aktuellen Zustand des zugehörigen Betätigers. Befindet sich der Betätiger im Bereich des Eingangsteils 52 und werden die Freigabesignale 88, 90 einwandfrei empfangen, erzeugen die Mikrocontroller 30, 32 mit Hilfe der Schaltelemente 34, 36 zwei Ausgangssignale, die den Freigabesignalen 88, 90 nachgebildet sind. Sie könnten sich jedoch auch von den Taktsignalen 88, 90 unterscheiden, beispielsweise hinsichtlich ihrer Frequenz. Der zweite Sicherheitsschalter 18b empfängt die nachgebildeten Freigabesignale und bildet diese seinerseits am Ausgang nach, wenn er ebenfalls eine geschlossene Schutztür und einwandfreie Funktion feststellt. Die Sicherheitssteuerung 20 erhält die nachgebildeten Freigabesignale über die Leitungen 92, 94.

Wenn nun der Sicherheitsschalter 18a das Öffnen der ihm zugeordneten Schutztür detektiert, d.h. wenn der zugeordnete Betätiger seinen Zustand wechselt, öffnen die Mikrocontroller 30, 32 die Schaltelemente 34, 36. Der nachfolgende Sicherheitsschalter 18b erhält folglich nicht mehr die nachgebildeten Freigabesignale. Dies wird von den Mikrocontrollern im Sicherheitsschalter 18b erkannt und durch Abschalten der Schaltelemente 34, 36 an die Sicherheitssteuerung 20 gemeldet. Diese kann daraufhin den Antrieb 82 abschalten.

In gleicher Weise erfolgt der Signalfluss, wenn der Sicherheitsschalter 18a einen Funktionsfehler detektiert, beispielsweise einen Querschluss an den eingangs- oder ausgangsseitigen Anschlüssen, ein Durchlegieren eines der Schaltelemente 34, 36 oder einen sonstigen Funktionsfehler. Nach einer kurzen Wartezeit, die in den Mikrocontrollern aller Sicherheitsschalter und der Sicherheitssteuerung hinterlegt ist, erzeugt der Sicherheitsschalter 18a ein Datentelegramm 96 auf zumindest einer seiner Ausgangsleitungen, indem er zumindest eines der Schaltelemente 34, 36 pulsweise schließt und wieder öffnet. Der nachfolgende Sicherheitsschalter 18b empfängt dieses Datentelegramm und gibt es an die Sicherheitssteuerung 20 in gleicher Weise weiter. Bei Bedarf kann er auch weitere Informationen in das Datentelegramm 96 integrieren.

In einem Ausführungsbeispiel ist das Datentelegramm 96 wie bei einer asynchronen, seriellen Schnittstelle realisiert, d.h. es beginnt mit einem definierten Startbit und endet mit einem definierten Stoppbit. Dazwischen liegt eine beliebige oder festgelegte Anzahl an Datenbits. In einem anderen Ausführungsbeispiel beinhaltet jedes Datentelegramm 96 eine festgelegte Anzahl an Impulsen mit definierter Impulsdauer. Die Bedeutung jedes einzelnen Impulses hängt von dem Protokoll ab, das zwischen den Sicherheitsschaltern 18 und der Sicherheitssteuerung 20 festgelegt ist.

In gleicher Weise erzeugt der Sicherheitsschalter 18b ein eigenes Datentelegramm 96, wenn er seinerseits einen Funktionsfehler feststellt. Im Unterschied zu der bekannten Anordnung kann der Sicherheitsschalter 18b seine Datentelegramme unabhängig davon erzeugen, ob der Sicherheitsschalter 18a die Schaltelemente 34, 36 geöffnet oder geschlossen hat.

In einem bevorzugten Ausführungsbeispiel beinhalten die Datentelegramme der Sicherheitsschalter 18a, 18b eine Adressinformation, die denjenigen Sicherheitsschalter identifiziert, der eine Information an die übergeordnete Sicherheitssteuerung 20 melden möchte. Die jeweilige Adresse kann den Sicherheitsschalter 18a, 18b auf verschiedene Weise zugeordnet werden. Beispielsweise kann jeder Sicherheitsschalter 18a, 18b mit einem mehrstufigen Adresswahlschalter (hier nicht gezeigt) versehen sein, an dem die zugeordnete Adresse eingestellt wird. In einem anderen Ausführungsbeispiel verwenden die Sicherheitsschalter 18a, 18b als Adresse jeweils die Codierung 58 der ihnen zugeordneten Betätiger 16.

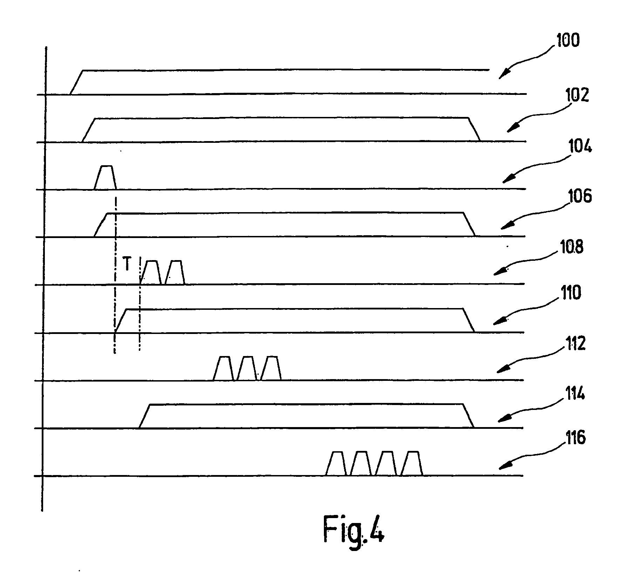

In einem weiteren Ausführungsbeispiel wird den in Reihe geschalteten Sicherheitsschaltern 18a, 18b in einem Initialisierungsmodus nach Inbetriebnahme der Sicherheitsschaltung 80 eine Adresse zugewiesen. Ein bevorzugtes Verfahren, wie diese Adresszuweisung erfolgt, ist anhand Fig. 4 dargestellt.

Fig. 4 zeigt die Signaldiagramme für diesen Initialisierungsmodus. Die oberste Impulsfolge 100 ist das Einschalten der Betriebsspannung U_{B} für sämtliche Komponenten der Sicherheitsschaltung 80. Bei Bezugsziffer 102 ist das Signal am ersten Taktausgang der Sicherheitssteuerung 20, d.h. das Signal auf der Leitung 88 dargestellt. Bei Bezugsziffer 104 ist das Signal am zweiten Taktausgang der Sicherheitssteuerung 20, d.h. das Signal auf Leitung 90 dargestellt. Der erste Sicherheitsschalter 18 erhält also nach dem Einschalten der Betriebsspannung U_{B} an seinem Eingang 60ein Dauer-High und an seinem Eingang 62 einen einzelnen Impuls. Sobald er diesen erkennt, bildet er das an seinem Anschluss 60 anliegende Signal (Dauer-High) an seinem Ausgang 44 nach (Bezugsziffer 106). Nach einer Wartezeit T erzeugt er dann an seinem Ausgang 46 zwei Impulse, wie bei Bezugsziffer 108 dargestellt. Die Wartezeit T dient zum Erkennen, ob weitere Impuls eingangsseitig empfangen werden.

Das zweite Sicherheitsschaltgerät 18b empfängt an seinen Eingängen 60, 62 die Signale 106, 108 und bildet diese an seinen Ausgängen 44, 46 nach. Dabei fügt es den Einzelimpulsen 108, die es am Anschluss 62 empfängt, einen weiteren Einzelimpuls hinzu. An den Ausgängen des zweiten Sicherheitsschalters 18b liegen folglich die Impulsfolgen an, die bei den Bezugsziffern 110, 112 dargestellt sind. In gleicher Weise würden weitere Sicherheitsschaltgeräte 18c, 18d etc. (in Fig. 3 nicht dargestellt) auf der einen Signalleitung ein Dauer-High nachbilden (Bezugsziffer 114) und auf der zweiten Signalleitung eine Impulsfolge, und jeder Sicherheitsschalter würde die Impulsfolge um einen Impuls erhöht.

Am Ende der Kette erhält die Sicherheitssteuerung 20 die Signale gemäß den Bezugsziffern 114, 116. Aus dem Signal 114 erkennt die Sicherheitssteuerung 20, dass die Verdrahtung des Kanals A stimmt. Aus der Impulsfolge 116 erkennt die Sicherheitssteuerung 20, dass die Verdrahtung des Kanals B stimmt. Außerdem kann sie die Anzahl der in Reihe angeordneten Sicherheitsschalter 18a, 18b etc. aus der Anzahl der Impulse minus 1 bestimmen. In gleicher Weise kann jeder Sicherheitsschalter 18a, 18b seine Adresse aus der Anzahl der empfangenen Impulse erkennen. Auf diese Weise kann beim Einschalten der Sicherheitsschaltung 80 eine individuelle Adresse an jeden in Reihe angeordneten Sicherheitsschalter automatisch zugewiesen werden. Wird die Sicherheitsschaltung 80 später verändert, erfolgt eine erneute und korrekte Adresszuordnung an die dann vorhandene Konfiguration automatisch beim Wiedereinschalten.

Die Flexibilität der neuen Meldegeräte wird hier noch weiter durch den bislang nicht erläuterten Eingangsanschluss 64 erhöht. Dieser Anschluss kann verwendet werden, um ein externes Rückkopplungssignal in den Sicherheitsschalter 18 einzuspeisen. Damit ist es beispielsweise möglich, dass der Sicherheitsschalter 18 einen Schütz mit zwangsgeführten Kontakten eigenständig, d.h. ohne ein bislang übliches Sicherheitsschaltgerät oder eine entsprechende Sicherheitssteuerung ansteuert. Es genügt, wenn der zwangsgeführte Öffnerkontakt des Schützes auf den Rückkoppeleingang 64 des Sicherheitsschalters 18 geführt ist.

In weiteren Ausführungsbeispielen besitzen Meldegeräte, wie der gezeigte Sicherheitsschalter 18, ferner einen weiteren Eingangsanschluss zum Anlegen eines Startsignals. Damit ist es ohne die bislang übliche Sicherheitssteuerung möglich, auch einen überwachten Wiederanlauf der Anlage zu realisieren.

Des weiteren kann die jeweilige Funktion der Meldegeräte 18 über den Eingangsanschluss 64 parametriert werden, wie dies beispielsweise aus DE 100 16 712 A1 bekannt ist. Außerdem kann eine Parametrierung von außen mit Hilfe unterschiedlicher Transpondercodierungen erfolgen.

## Patentansprüche

1. Sicherheitsschalteinrichtung für eine Sicherheitsschaltung, mit einem Steuerteil (30, 32) zum Verarbeiten eines Eingangssignals (60, 62, 64; 52) und mit zumindest einem Schaltelement (34, 36), das zumindest einen aktiven und einen inaktiven Schaltzustand besitzt, wobei der Steuerteil (30, 32) dazu ausgebildet ist, das Schaltelement (34, 36) anzusteuern, um ein vom Eingangssignal abhängiges Ausgangssignal an einem Ausgang (44, 46) zu erzeugen, ferner mit einer Diagnosefunktionalität zum Erkennen eines Funktionsfehlers, wobei der Steuerteil (30, 32) dazu ausgebildet ist, das Schaltelement (34, 36) in den inaktiven Zustand zu steuern, wenn ein Funktionsfehler erkannt ist, **dadurch gekennzeichnet, dass** der Steuerteil (30, 32) ferner dazu ausgebildet ist, nach einer in dem Steuerteil (30, 32) hinterlegten Wartezeit ein Datentelegramm (96) an dem Ausgang (44, 46) zu erzeugen, das von dem erkannten Funktionsfehler abhängt.

2. Sicherheitsschalteinrichtung nach Anspruch 1, **dadurch gekennzeichnet, dass** der Steuerteil (30, 32) dazu ausgebildet ist, das Datentelegramm (96) mit Hilfe des Schaltelements (34, 36) zu erzeugen.

3. Sicherheitsschalteinrichtung nach Anspruch 1 oder 2, **gekennzeichnet durch** zumindest zwei zueinander redundante Schaltelemente (34, 36), die von dem Steuerteil (30, 32) redundant ansteuerbar sind.

4. Sicherheitsschalteinrichtung nach einem der Ansprüche 1 bis 3, **dadurch gekennzeichnet, dass** der Steuerteil (30, 32) dazu ausgebildet ist, das Schaltelement (34, 36) pulsweise anzusteuern, um ein pulsförmiges Datentelegramm (96) zu erzeugen.

5. Sicherheitsschalteinrichtung nach einem der Ansprüche 1 bis 4, **dadurch gekennzeichnet, dass** der Steuerteil (30, 32) dazu ausgebildet ist, eine Adresse in das Datentelegramm (96) einzubinden.

6. Sicherheitsschalteinrichtung nach einem der Ansprüche 1 bis 5, **gekennzeichnet durch** zumindest einen Eingang (60, 62) für ein externes Freigabesignal (88, 90), welches das Eingangssignal bildet.

7. Sicherheitsschalteinrichtung nach Anspruch 6, **gekennzeichnet durch** einen Initialisierungsmodus, in dem der Steuerteil (30, 32) mit Hilfe des zumindest einen Schaltelements (34, 36) eine Pulsfolge (108, 112, 116) erzeugt, die mehr Pulse beinhaltet, als ein an dem Eingang zugeführtes Freigabesignal (88, 90).

8. Sicherheitsschalteinrichtung nach einem der Ansprüche 1 bis 7, **gekennzeichnet durch** zumindest einen Eingangsteil (52) für einen Betätiger (16), der zwischen einem ersten und zumindest einem zweiten Zustand wechselbar ist, wobei der Eingangsteil (52) das Eingangssignal erzeugt.

9. Sicherheitsschaltung zum fehlersicheren Abschalten einer gefahrbringenden Anlage (10), mit einer Vielzahl von Sicherheitsschalteinrichtungen (18a, 18b) nach einem der Ansprüche 1 bis 7 und mit einer übergeordneten Sicherheitssteuerung (20), die dazu ausgebildet ist, einen Stromversorgungspfad (26) zu der Anlage (10) zu unterbrechen, wobei die Sicherheitssteuerung (20) ferner dazu ausgebildet ist, die Datentelegramme (96) aller Sicherheitsschalteinrichtungen (18a, 18b) aufzunehmen und zu verarbeiten.

10. Sicherheitsschaltung nach Anspruch 9, **dadurch gekennzeichnet, dass** die Vielzahl von Sicherheitsschalteinrichtungen (18a, 18b) in Reihe zueinander an die Sicherheitssteuerung (20) angeschlossen sind.

## Claims

1. A safety switch for a safety circuit, comprising a control part (30, 32) for processing an input signal (60, 62, 64; 52) and comprising at least one switching element (34, 36) having at least one active and one inactive switching state, wherein the control part (30, 32) is configured to control the switching element (34, 36) in order to generate an output signal dependent on the input signal at an output (44, 46), further comprising a diagnostic function for identifying a functional fault, wherein the control part (30, 32) is configured to transfer the switching element (34, 36) into the inactive state when a functional fault is identified, **characterized in that** the control part (30, 32) is further configured to generate a data message (96) at the output (44, 46) after a waiting time provided in the control part (30, 32), which data message is dependent on the functional fault identified.

2. The safety switch of claim 1, **characterized in that** the control part (30, 32) is configured to generate the data message (96) by means of the switching element (34, 36).

3. The safety switch of claim 1 or 2, **characterized by** at least two mutually redundant switching elements (34, 36) arranged for being controlled redundantly by the control part (30, 32).

4. The safety switch of one of claims 1 to 3, **characterized in that** the control part (30, 32) is configured to control the switching element (34, 36) pulsewise in order to generate a pulse-shaped data message (96).

5. The safety switch of one of claims 1 to 4, **characterized in that** the control part (30, 32) is configured to include an address in the data message (96).

6. The safety switch of one of claims 1 to 5, **characterized by** at least one input (60, 62) for an external enable signal (88, 90) which forms the input signal.

7. The safety switch of claim 6, **characterized by** an initialization mode in which the control part (30, 32) generates, by means of the at least one switching element (34, 36), a pulse sequence (108, 112, 116) which contains more pulses than an enable signal (88, 90) supplied at the input.

8. The safety switch of one of claims 1 to 7, **characterized by** at least one input part (52) for an actuator (16) which is adapted to be alternated between a first state and at least one second state, wherein the input part (52) generates the input signal.

9. A safety circuit for switching off a hazardous installation (10) in a fail safe manner, comprising a plurality of safety switches (18a, 18b) according to one of claims 1 to 7, and comprising a higher-level safety controller (20) which is configured to interrupt a power supply path (26) to the installation (10), wherein the safety controller (20) is also configured to receive and process the data messages (96) of the safety switches (18a, 18b).

10. The safety circuit of claim 9, wherein the plurality of safety switches (18a, 18b) are connected to the safety controller (20) in series with one another.

## Revendications

1. Dispositif de commutation de sécurité pour un circuit de sécurité, avec une partie commande (30, 32) pour traiter un signal d'entrée (60, 62, 64 ; 52) et avec au moins un élément de commutation (34, 36), qui possède au moins un état de commutation actif et un état de commutation inactif, la partie commande (30, 32) étant conçue pour commander l'élément de commutation (34, 36), afin de produire à une sortie (44, 46) un signal de sortie dépendant du signal d'entrée, avec, en outre, une fonction diagnostique pour détecter une erreur de fonctionnement, la partie commande (30, 32) étant conçue pour placer l'élément de commutation (34, 36) à l'état inactif, lorsqu'une erreur de fonctionnement est détectée, **caractérisé en ce que** la partie commande (30, 32) est en outre conçue pour produire à la sortie (44, 46), après un temps d'attente déposé dans la partie commande (30, 32), un télégramme de données (96) qui dépend de l'erreur de fonctionnement détectée.

2. Dispositif de commutation de sécurité selon la revendication 1, **caractérisé en ce que** la partie commande (30, 32) est conçue pour produire le télégramme de données (96) à l'aide de l'élément de commutation (34, 36).

3. Dispositif de commutation de sécurité selon la revendication 1 ou 2, **caractérisé par** au moins deux éléments de commutation redondants l'un par rapport à l'autre (34, 36), qui peuvent être commandés de manière redondante par la partie commande (30, 32).

4. Dispositif de commutation de sécurité selon l'une quelconque des revendications 1 à 3, **caractérisé en ce que** la partie commande (30, 32) est conçue pour commander l'élément de commutation (34, 36) par impulsions, afin de produire un télégramme de données en forme d'impulsions (96).

5. Dispositif de commutation de sécurité selon l'une quelconque des revendications 1 à 4, **caractérisé en ce que** la partie commande (30, 32) est conçue pour intégrer une adresse dans le télégramme de données (96).

6. Dispositif de commutation de sécurité selon l'une quelconque des revendications 1 à 5, **caractérisé par** au moins une entrée (60, 62) pour un signal externe de validation (88, 90), lequel constitue le signal d'entrée.

7. Dispositif de commutation de sécurité selon la revendication 6, **caractérisé par** un mode d'initialisation dans lequel la partie commande (30, 32) produit, à l'aide de l'au moins un élément de commutation (34, 36), une succession d'impulsions (108, 112, 116), qui contient plus d'impulsions qu'un signal de validation (88, 90) amené à l'entrée.

8. Dispositif de commutation de sécurité selon l'une quelconque des revendications 1 à 7, **caractérisé par** au moins une partie entrée (52) pour un actionneur (16), qui peut alterner entre un premier et au moins un second état, la partie entrée (52) produisant le signal d'entrée.

9. Circuit de sécurité pour couper sans défaillance une installation dangereuse (10), avec une pluralité de dispositifs de commutation de sécurité (18a, 18b) selon l'une quelconque des revendications 1 à 7 et avec une commande de sécurité superposée (20), qui est conçue pour interrompre un tracé d'alimentation en courant (26) vers l'installation (10), la commande de sécurité (20) étant, en outre, conçue pour recevoir et traiter les télégrammes de données (96) de tous les dispositifs de commutation de sécurité (18a, 18b).

10. Circuit de sécurité selon la revendication 9, **caractérisé en ce que** la pluralité de dispositifs de commutation de sécurité (18a, 18b) est raccordée en série à la commande de sécurité (20).
